# EUROPÄISCHE PATENTANMELDUNG

(11) **EP 0 563 450 A1**
(43) Veröffentlichungstag der Anmeldung: **06.10.1993**
(21) Anmeldenummer: 92120747.8
(22) Anmeldetag: 04.12.1992
(51) Int. Cl.: H04B 1/50

(54) **Vorrichtung zur Filterung der Signale einer Antenneneinrichtung sowie eine Sende-Empfangseinrichtung mit zwei oder mehreren Antennen**

(30) Priorität: 07.12.1991 DE 9115204 U
(71) Anmelder: RR ELEKTRONISCHE GERÄTE GmbH & Co. KG, D-24159 Kiel (DE)
(72) Erfinder: Rümmeli, Bernd, D-2301 Strande (DE); Mann, Olaf, D-8130 Starnberg (DE)
(74) Vertreter: Heldt, Gert, Dr. Dipl.-Ing.

(57) **Zusammenfassung**

Bei einer Vorrichtung zur Filterung der Signale einer Antenneneinrichtung, die mindestens eine Antenne (3) aufweist, ist mindestens ein Empfangsfilter (8,9) vorgesehen, das die der Antenneneinrichtung zugeführten Sendesignale weitgehend zurückhält. Das Empfangsfilter (8,9) läßt Signale mit einer Frequenz aus einem breiten Band, das abseits der Frequenz des gesendeten Signals liegt, weitgehend unbeeinflußt durch. Es ist aus Induktivitäten (13,14) und/oder Kapazitäten (15,16) gebildet. Das Empfangsfilter (8,9) kann als ein Parallelschwingkreis ausgebildet sein. Es kann als ein Bandpaß vorgesehen sein. Das Empfangsfilter (8,9) führt die von der Antenneneinrichtung empfangenen Signale einem Empfänger zu, der die Empfangssignale aufbereitet. Das Empfangsfilter (8,9) führt die von der Antenneneinrichtung empfangenen Signale einem separaten Ausgang zu. Zwischen dem Empfangsfilter (8,9) und der Antenne (3) ist ein Impedanzwandler (18) geschaltet. Dieser ist aus einer Induktivität gebildet. Er kann als ein Netzwerk realisiert sein. Dieses ist mit Induktivitäten und/oder Kapazitäten gebildet und kann einen oder mehrere Leitungsformatoren aufweisen. Der Impedanzwandler dient zur Anpassung der Antenne an die Impedanz des Kabels, das die Antenneneinrichtung speist.

## Beschreibung

Die Erfindung betrifft eine Vorrichtung zur Filterung der Signale einer Antenneneinrichtung, die mindestens eine Antenne aufweist sowie eine Sende-/Empfangseinrichtung mit zwei oder mehreren Antennen.

Derartige Vorrichtungen werden beispielsweise bei mobilen Funkanwendungen verwendet. Insbesondere bei Seefunkstellen ist es in der Regel erforderlich, daß ein Empfang auf mehreren Frequenzen bei gleichzeitigem Senden möglich sein muß. Bei Seefunkstellen ist beispielsweise der Empfang von Ortungsfunk, Wetterfunk usw. erforderlich. Ferner besteht oft der Wunsch, auch Rundfunk- und Fernsehprogramme empfangen zu können. Ein Nachrichtenaustausch zwischen der mobilen Stelle und anderen Funkstationen erfolgt üblicherweise auf den UKW-Seefunkfrequenzen. Zudem wird in jüngster Zeit häufig der Wunsch nach einem Mobiltelefon geäußert, das im C- oder D-Funknetz sendet und empfängt.

Es ist üblich, für jeden Funkdienst jeweils eine eigene entsprechend den Anforderungen dimensionierte Antenne zu verwenden. Darüber hinaus ist es auch bekannt, Antennen mit einer breitbandigen Frequenzcharakteristik zu verwenden, die mit nachgeschalteten Frequenzweichen bzw. -filtern versehen sind. Ferner ist es prinzipiell auch möglich, umschaltbare Freqenzcharakteristiken vorzusehen.

Bei der üblichen Verwendung von mehreren Antennen, von denen jeweils eine einer bestimmten Frequenz zugeordnet ist, treten aufgrund der Vielzahl der erforderlichen Antennen sowohl räumliche als auch mechanische Probleme bei der Installation auf. Darüber hinaus beeinflussen sich die Antennen beim Senden und Empfangen gegenseitig. Bei umschaltbaren Frequenzcharakteristiken ist es nicht möglich, gleichzeitig eine Empfangs- sowie einen Sendebetrieb über eine einzige Antenne durchzuführen.

Aufgabe der vorliegenden Erfindung ist es daher, eine Vorrichtung der einleitend genannten Art derart zu konstruieren, daß gleichzeitig sowohl ein breitbandiger Empfang als auch ein schmalbandiger Sendevorgang über ein und dieselbe Antenne durchführbar ist.

Diese Aufgabe wird erfindungsgemäß dadurch gelöst, daß mindestens ein Empfangsfilter vorgesehen ist, das die der Antenneneinrichtung zugeführten Sendesignale weitgehend zurückhält.

Vorteilhafte Ausgestaltungen der Erfindung sind in den abhängigen Ansprüchen angegeben.

Aufgrund der erfindungsgemäßen Dimensionierung des Empfangs- bzw. Sendefilters ist es möglich, über eine gemeinsame Antenne gleichzeitig einen Sende- und einen Empfangsbetrieb auf unterschiedlichen Frequenzen durchzuführen. Das Empfangsfilter verhindert weitgehend, daß Sendesignale in den Bereich des Empfängers gelangen. Ein zusätzlicher Sendefilter wiederum verhindert, daß Empfangssignale, die in der Regel deutlich schwächer als die Sendesignale sind, in den Bereich eines Sendegenerators gelangen können. Durch eine an die jeweilige Verwendung angepaßte Dimensionierung der Filter kann die jeweils gewünschte Bandbreite eingestellt werden.

Gemäß einer bevorzugten Ausführungsform der Erfindung ist vorgesehen, daß für die Einspeisung sowie die Auskopplung von Sende- und Empangssignalen ein gemeinsamer Anschluß vorgesehen ist. Das Empfangs- und das Sendefilter der erfindungsgemäßen Vorrichtung sind im wesentlichen parallel zueinander geschaltet. Durch diese konstruktive Aufteilung ist es beispielsweise möglich, das Empfangsfilter zu unterteilen und zwischen die Teile des Empfangsfilters einen Verstärker für das empfangene Signal zu schalten. Hierdurch wird eine Aktivantenne bereitgestellt, bei der eine Beaufschlagung des Verstärkers mit Sendesignalen verhindert wird.

Bei einer weiteren bevorzugten Ausführungsform ist vorgesehen, daß sowohl das Empfangsfilter als auch das Sendefilter aus Induktivitäten bzw. Kapazitäten gebildet ist. Ferner ist es von Vorteil, einen Sendefilter als einen Serienschwingkreis und die Teile des Empfangsfilter als Parallelschwingkreise auszubilden. Hierdurch ist es möglich mit einfachen elektronischen Bauelementen in besonders kostengünstiger Weise sowohl eine Durchlaßwirkung für bestimmte Frequenzen als auch eine Sperrwirkung für die anderen Frequenzen zu realisieren.

Weitere Einzelheiten der vorliegenden Erfindung ergeben sich aus der nachfolgenden ausführlichen Beschreibung und den beigefügten Zeichnungen, in denen bevorzugte Ausführungsformen der Erfindung beispielsweise veranschaulicht sind.

In den Zeichnungen zeigen:

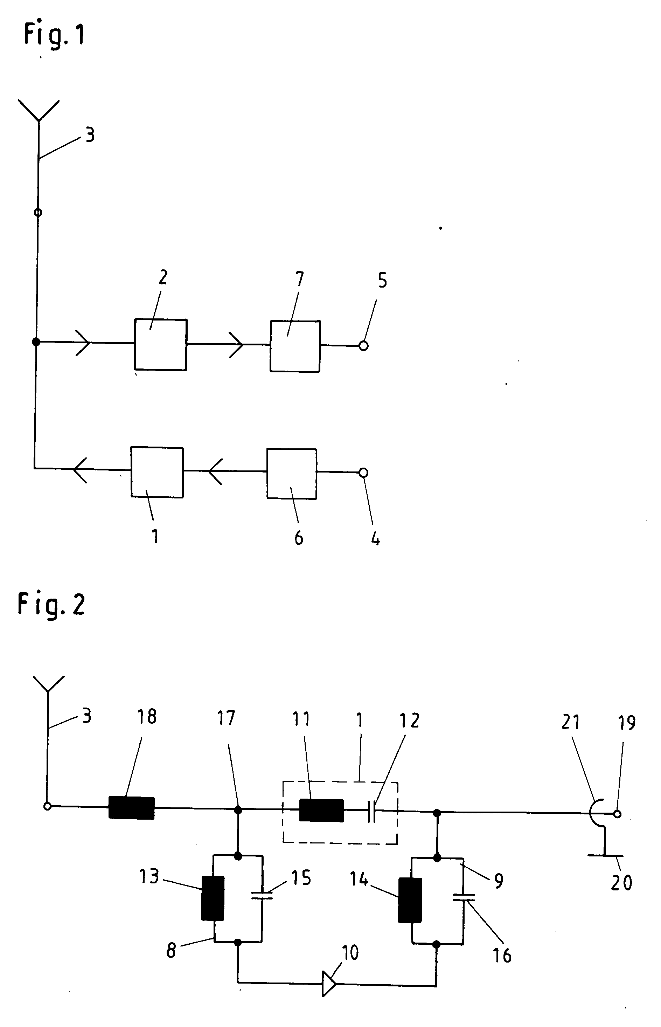

- Fig. 1:: ein Blockschaltbild einer Antenne, die mit einem Sende filter und einem Empfangsfilter versehen ist
- Fig. 2:: ein Schaltbild eines Antennenfilters, bei dem sowohl Serien- als auch Parallelschwingkreise verwendet werden und zur Verstärkung der Empfangssignale ein Verstärker vorgesehen ist und
- Fig. 3a bis d:: vier Systemskizzen, aus denen sich Sende- und Empfangsantennenkombination unter Beteiligung von UKW-Seefunk ergeben.

Eine Vorrichtung zur Filterung von Sende- und Empfangssignalen besteht im wesentlichen aus einem Sendefilter (1) sowie einem Empfangsfilter (2). Sowohl das Sendefilter (1) als auch das Empfangsfilter (2) sind an eine Antenne (3) angeschlossen. Bei einer Ausführungsform mit einem separaten Eingang (4) sowie einem separaten Ausgang (5) wird das Sendefilter (1) von einem Sender (6) gespeist und die vom Empfangsfilter (2) übermittelten Signale werden einem Empfänger (7) zugeleitet. Die zu sendenden Signale können über den Eingang (4) in den Bereich des Senders (6) eingeleitet werden und erfahren hier ggf. eine erforderliche Modulation. Die vom Empfänger (7) aufbereiteten Empfangssignale können am Ausgang (5) abgenommen werden.

Zur Ausbildung einer Aktivantenne ist es insbesondere zweckmäßig, das Empfangsfilter (2) in Teilfilter (8,9) aufzuspalten. Zwischen den Teilfiltern (8,9) ist ein Verstärker (10) angeordnet. Durch die Teilfilter (8,9) wird verhindert, daß Teile des Sendesignales in den Bereich des Einganges bzw. des Ausganges des Verstärkers gelangen können.

Das Sendefilter (1) wird als Serienschwingkreis ausgebildet, der aus einer Induktivität (11) sowie einem Kondensator (12) besteht. Das Empfangsfilter (2) bzw. die Teilfilter (8,9) bestehen aus Parallelschwingkreisen, die aus Induktivitäten (13,14) sowie Kondensatoren (15,16) ausgebildet sind. Zwischen einer Verbindungsstelle (17), an der das Sendefilter (1) und das Empfangsfilter (2) elektrisch miteinander verbunden sind, und der Antenne (3) ist ein Impedanzwandler (18) vorgesehen. Der Impedanzwandler (18) kann aus einer Induktivität ausgebildet sein. Ein gemeinsamer Anschluß (19), über den sowohl Sendesignale zugeführt als auch Empfangssignale entnommen werden, ist mit einer an eine Erdung (20) angeschlossenen Abschirmung (21) versehen.

Zu einem Betrieb der Vorrichtung wird das Sendefilter (1) zweckmäßigerweise schmalbandig und das Empfangsfilter (2) breitbandig abgestimmt. Sendesignale werden über das Sendefilter (1), das für die Sendefrequenz im wesentlichen als ein Kurzschluß wirkt, und den Impedanzwandler (18) an die Antenne (3) geleitet. Statt einer Ausbildung des Impedanzwandlers (18) aus einer Induktivität ist es auch möglich, geeignete Netzwerke zu verwenden, die Induktivitäten bzw. Kapazitäten aufweisen und bei denen alternativ oder ergänzend Leitungstransformatoren vorgesehen sind. Insbesondere dient der Impedanzwandler (18) zur einer Anpassung der Antenne (3) an eine Speisekabelimpedanz. Das Speisekabel wird mit dem Anschluß (19) verbunden.

Empfangene Signale werden über den Impedanzwandler (18) und das Teilfilter (8) einem Eingang des Verstärkers (10) zugeführt. Das Teilfilter (8) weist für die Empfangsfrequenzen einen sehr geringen Widerstand auf. Das Sendefilter (1) wirkt hingegen für die Empfangsfrequenzen hochohmig. Das über den Verstärker (10) geführte Empfangssignal wird über das zweite Teilfilter (9) in den Bereich des Anschlusses (19) geleitet. Durch die Kombination der Teilfilter (8,9) und des Sendefilters (1) ist eine Selbsterregung des Verstärkers (10) ausgeschlossen.

Bei einer Verwendung eines gemeinsamen Anschlusses (19) sowohl für die Sende- als auch für die Empfangssignale werden im Bereich eines über die Speiseleitung mit dem Anschluß (19) verbundenen Endgerätes zur Signaltrennung geeignete Sperr- bzw. Bandpaßfilter verwendet. Zur Energieversorgung des Verstärkungsteiles ist insbesondere daran gedacht, eine Gleichstromfernspeisung vorzusehen.

Bei einer Verwendung im Bereich des Seefunkes ist es beispielsweise möglich, das Sendefilter (1) und das Empfangsfilter (2) derart zu dimensionieren, daß ein Sendebetrieb im Zwei-Meter-Bereich möglich ist. Durch eine angepaßte Dimensionierung des Empfangsfilters (2) ist ein breitbandiger Empfangsbetrieb von einem ausgedehnten Langwellenbereich bis in den Drei-Meter-Bereich möglich.

Neben der Verwendung im Bereich des bereits erwähnten Seefunkes sind auch eine Vielzahl von anderen Verwendungen denkbar. Beispielsweise ist es möglich, die Vorrichtung im Bereich von Kraftfahrzeugen anzuordnen, die mit geeigneten Kommunikationsgeräten ausgestattet sind. Darüber hinaus sind auch Anwendungen im Bereich des Mobilfunkes sowie bei schnurlosen Telefonen und Autotelefonen denkbar. Grundsätzlich kann jedoch auch ein Einsatz bei beliebigen anderen Übertragungssystemen erfolgen, die zur Signalübertragung ein Trägermedium mit unterschiedlichen Frequenzen für Sende- und Empfangssignale verwenden.

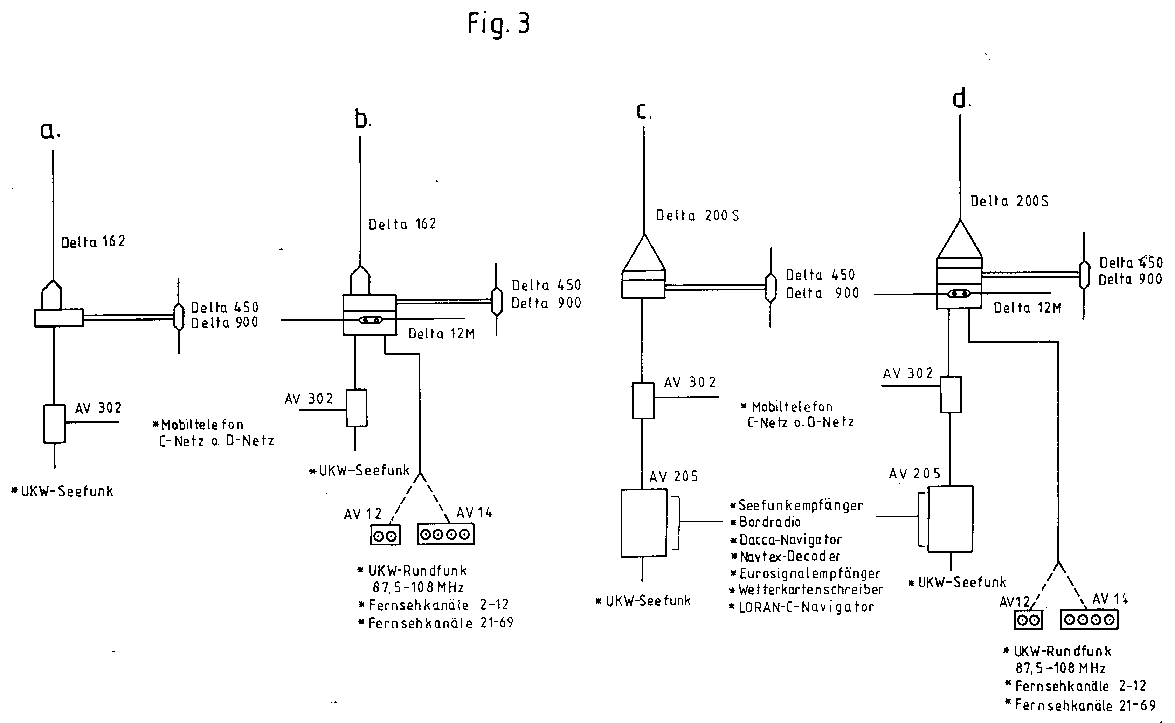

Wie sich insbesondere aus den Figuren 3 a bis d ergibt, hat es sich in der Praxis als zweckmäßig erwiesen, wenn neben dem Sende- und Empfangsbetrieb auf Seefunkfrequenzen auch ein Sende- und Empfangsbetrieb auf Mobilfunkfrequenzen im C- oder D-Netz durchgeführt werden soll, zwei entsprechende separate Antennen vorzusehen. Bei dieser Antenneneinrichtung ist eine gemeinsame Speiseleitung für beide Antennen vorgesehen. In die Speiseleitung können dann, je nach Anwendung, eine oder mehrere der erfindungsgemäßen Vorrichtungen in Serie zueinander und mit der Speiseleitung geschaltet werden. Dadurch werden Verzweigungen geschaffen, an denen jeweils ein Empfangssignal unterschiedlicher Frequenz ausgekoppelt wird. Ferner können an den Stellen, an denen UKW-, Seefunk- oder Mobiltelefonsignale ausgekoppelt werden, auch entsprechende Sendesignale auf die Speiseleitung der Antenneneinrichtung eingekoppelt werden. An den Stellen, an denen über die erfindungsgemäße Vorrichtung Signale für das Bordradio, die Dacca-Navigation, Navtex-Signale, Euro-Signale, Wetterkarten-Signale oder LORAN-C-Signale ausgekoppelt werden, ist lediglich ein Empfangsbetrieb vorgesehen, so daß ein Sendebetrieb entsprechender Signale nicht vorgesehen ist. Daher kann an solchen Stellen auf ein Sendefilter verzichtet werden.

Zudem kann es in der Praxis sinnvoll sein eine Antenneneinrichtung zu verwenden, die eine Seefunkantenne, eine Mobilfunkantenne und eine Fernseh- und Rundfunkantenne aufweist. Gegebenenfalls ist eine Vorrichtung gemäß der Erfindung in der separaten Speiseleitung der Rundfunk- und Fernsehantenne verzichtbar.

## Patentansprüche

1. Vorrichtung zur Filterung der Signale einer Antenneneinrichtung, die mindestens eine Antenne (3) aufweist, dadurch gekennzeichnet, daß mindestens ein Empfangsfilter (2) vorgesehen ist, das die der Antenenneneinrichtung zugeführten Sendesignale weitgehend zurückhält.

2. Vorrichtung nach Anspruch 1, dadurch gekennzeichnet, daß das Empfangsfilter (2) Signale mit einer Frequenz aus einem breiten Band, das abseits der Frequenz des gesendeten Signals liegt, weitgehend unbeeinflußt durchläßt.

3. Vorrichtung nach Anspruch 1 und 2, dadurch gekennzeichnet, daß das Empfangsfilter (2) aus Induktivitäten und/oder Kapazitäten gebildet ist.

4. Vorrichtung nach Anspruch 3, dadurch gekennzeichnet, daß das Empfangsfilter (2) als ein Parallelschwingkreis ausgebildet ist.

5. Vorrichtung nach Anspruch 3, dadurch gekennzeichnet, daß das Empfangsfilter (2) als Bandpaß vorgesehen ist.

6. Vorrichtung nach einem der Ansprüche 1 bis 5, dadurch gekennzeichnet, daß das Empfangsfilter (2) die von der Antenneneinrichtung empfangenen Signale einem Empfänger (7) zuführt, der die Empfangssignale aufbereitet.

7. Vorrichtung nach einem der Ansprüche 1 bis 6, dadurch gekennzeichnet, daß das Empfangsfilter (2), die von der Antenneneinrichtung empfangenen Signale einem separaten Ausgang (5) der Vorrichtung zuführt.

8. Vorrichtung nach einem der Ansprüch 1 bis 7, dadurch gekennzeichnet, daß zwischen dem Empfangsfilter (2) und der Antenne (3) ein Impedanzwandler (18) geschaltet ist.

9. Vorrichtung nach Anspruch 8, dadurch gekennzeichnet, daß der Impedanzwandler (18) aus einer Induktivität gebildet ist.

10. Vorrichtung nach Anspruch 8, dadurch gekennzeichnet, daß der Impedanzwandler (18) durch ein Netzwerk realisiert ist.

11. Vorrichtung nach Anspruch 10, dadurch gekennzeichnet, daß das Netzwerk mit Induktivitäten und/oder Kapazitäten gebildet ist.

12. Vorrichtung nach Anspruch 10 bis 11, dadurch gekennzeichnet, daß das Netzwerk einen oder mehrere Leitungsformatoren aufweist.

13. Vorrichtung nach einem der Ansprüche 9 bis 12, dadurch gekennzeichnet, daß der Impedanzwandler (18) zur Anpassung der Antenne (3) an die Impedanz des Kabels dient, das die Antenneneinrichtung speist.

14. Vorrichtung nach einem der Ansprüche 1 bis 13, dadurch gekennzeichnet, daß das Empfangsfilter (2) aus Teilfiltern (8, 9) besteht, zwischen die ein Verstärker (10) geschaltet ist.

15. Vorrichtung nach Anspruch 14, dadurch gekennzeichnet, daß ein erstes Teilfilter (8) vor den Eingang des Verstärkers (10) und ein zweites Teilfilter (9) hinter den Ausgang des Verstärkers (10) geschaltet ist.

16. Vorrichtung nach Anspruch 15, dadurch gekennzeichnet, daß die Teilfilter (8, 9) das von der Antenenneinrichtung gesendete Signal von dem Verstärker (10) fernhalten.

17. Vorrichtung nach einem der Ansprüche 14 bis 16, dadurch gekennzeichnet, daß der Verstärker (10) das von dem ersten Teilfilter (8) zugeführte Empfangssignal der Antenneneinrichtung verstärkt und das verstärkte Signal über das zweite Teilfilter (9) abgibt.

18. Vorrichtung nach einem der Ansprüche 14 bis 17, dadurch gekennzeichnet, daß der Verstärker (10) eine Spannungsverstärkung im Bereich von 1 aufweist.

19. Vorrichtung nach einem der Ansprüche 14 bis 18, dadurch gekennzeichnet, daß eine Gleichstromferneinspeisung zur Energieversorgung des Verstärkers (10) vorgesehen ist.

20. Vorrichtung nach einem der Ansprüche 1 bis 19, dadurch gekennzeichnet, daß mindestens ein Sendefilter (1) vorgesehen ist, das die Empfangssignale aus der Antenneneinrichtung weitgehend zurückhält.

21. Vorrichtung nach Anspruch 10, dadurch gekennzeichnet, daß das Sendefilter (1) Signale aus einem schmalen Frequenzband um die Frequenz des zu sendenden Signals weitgehend unbeeinflußt durchläßt.

22. Vorrichtung nach einem der Ansprüche 20 oder 21, dadurch gekennzeichnet, daß das Sendefilter (1) als ein Bandmaß ausgebildet ist.

23. Vorrichtung nach einem der Ansprüche 20 bis 22, dadurch gekennzeichnet, daß das Sendefilter (1) aus Induktivitäten und/oder Kapazitäten gebildet ist.

24. Vorrichtung nach einem der Ansprüche 20 bis 23, dadurch gekennzeichnet, daß das Sendefilter (1) als Reihenschwingkreis ausgebildet ist.

25. Vorrichtung nach einem der Ansprüche 20 bis 24, dadurch gekennzeichnet, daß das Sendefilter (1) zwischen die Antenneneinrichtung und einen separaten Eingang (4) der Vorrichtung geschaltet ist.

26. Vorrichtung nach einem der Ansprüche 20 bis 25, dadurch gekennzeichnet, daß zwischen das Sendefilter (1) und die Antenneneinrichtung ein Impedanzwandler (18) geschaltet ist.

27. Vorrichtung nach einem der Ansprüche 1 bis 26, dadurch gekennzeichnet, daß das Sendefilter (1) im wesentlichen parallel zum Empfangsfilter (2) geschaltet ist.

28. Vorrichtung nach einem der Ansprüche 1 bis 27, dadurch gekennzeichnet, daß das Sendefilter (1) zwischen den Eingang des ersten Teilfilters (8) und den Ausgang des zweiten Teilfilters (9) geschaltet ist, wodurch eine Rückkoppelung des Ausgangssignals des Verstärkers (10) auf seinen Eingang verhindert ist.

29. Vorrichtung nach einem der Ansprüche 1 bis 28, dadurch gekennzeichnet, daß zur Einspeisung der Sendesignale und zur Ableitung der Empfangssignale ein gemeinsamer Anschluß (19) vorgesehen ist.

30. Vorrichtung nach Anspruch 29, dadurch gekennzeichnet, daß der Anschluß (19) über ein Speisekabel mit einem Endgerät verbunden ist, in dessen Bereich zur Auftrennung von Sende- und Empfangssignalen Sperr- sowie Wandpassfilter angeordnet sind.

31. Vorrichtung nach einem der Ansprüche 1 bis 30, dadurch gekennzeichnet, daß das Empfangsfilter (2) eine Empfangssignale im UKW-, Seefunkbereich oder im C- oder D-Funknetz für Mobiltelefone oder im Seefunkdienst, wie insbesondere Bordradio, Dacca-Navigator-Signale, Navtex-Signale, Eurosignale, Wetterkartensignale oder LORAN-C-Signale oder im UKW-Rundfunk oder Fernsehbereich durchlassende Frequenzcharakteristik hat.

32. Vorrichtung nach einem der Ansprüche 20 bis 31, dadurch gekennzeichnet, daß das Sendefilter (1) eine Sendesignale im UKW-Seefunkbereich oder im C- oder D-Funknetz für Mobiltelefone durchlassende Frequenzcharakteristik hat.

33. Vorrichtung nach einem der Ansprüche 1 bis 32, dadurch gekennzeichnet, daß die Antenne (3) eine Dipol-Antenne ist oder eine Geometrie zur Anpassung an eine 5/8-Wellenlänge aufweist und als eine Seefunkantenne oder eine UKW-Seefunkantenne oder eine UKW-Rundfunkantenne oder eine Mobilfunkantenne für das C- oder D-Netz oder als eine Fernsehantenne ausgebildet ist.

34. Sende-/Empfangseinrichtung mit zwei oder mehreren Antennen nach Anspruch 33, dadurch gekennzeichnet, daß mindestens einem Teil der Antennen jeweils eine entsprechende separate Vorrichtung nach einem der Ansprüche 1 bis 32 zugeordnet ist.
